# EUROPEAN PATENT APPLICATION

(11) **EP 2 066 157 A2**
(43) Date of publication of application: **03.06.2009**
(21) Application number: 08170158.3
(22) Date of filing: 27.11.2008
(51) Int. Cl.: H05K 1/02, H01L 23/498

(54) **Wiring substrate and manufacturing method thereof**

(30) Priority: 29.11.2007 JP 2007308583
(71) Applicant: Shinko Electric Industries Co., Ltd., Nagano-shi, Nagano 381-2287 (JP)
(72) Inventor: Sunohara, Masahiro, Nagano 381-2287 (JP)
(74) Representative: Zimmermann & Partner

(57) **Abstract**

In a wiring substrate (1A, 1B, 1C, 1D) having a wiring member (30B) made by layering insulating layers (20, 20a, 20b, 20c) and wiring layers (18, 18a, 18b, 18c, 18d), and a reinforcing body (50A) disposed between the insulating layers of this wiring member (30B), this reinforcing body (50A) is configured to cross plural linear members (51A).

## Description

### BACKGROUND OF THE INVENTION

The present invention relates to a wiring substrate and a manufacturing method thereof. In particular it relates to a wiring substrate made by disposing a reinforcing member in a wiring member formed by removing a support body after a wiring layer and an insulating layer are layered on the support body and a manufacturing method of the wiring substrate.

For example, a method for manufacturing a wiring substrate in which an electronic component is mounted includes a method for obtaining a wiring substrate by separating a wiring layer from a support body after a necessary wiring layer is formed in a state capable of being peeled on the support body. In the manufacturing method of the wiring substrate of this kind, there is the support body at the time of forming a build-up wiring layer, so that the build-up wiring layer can surely be formed with high accuracy. Also, after the build-up wiring layer is formed, the support body is removed, so that improvement in electrical characteristics and thinning of the wiring substrate manufactured can be achieved.

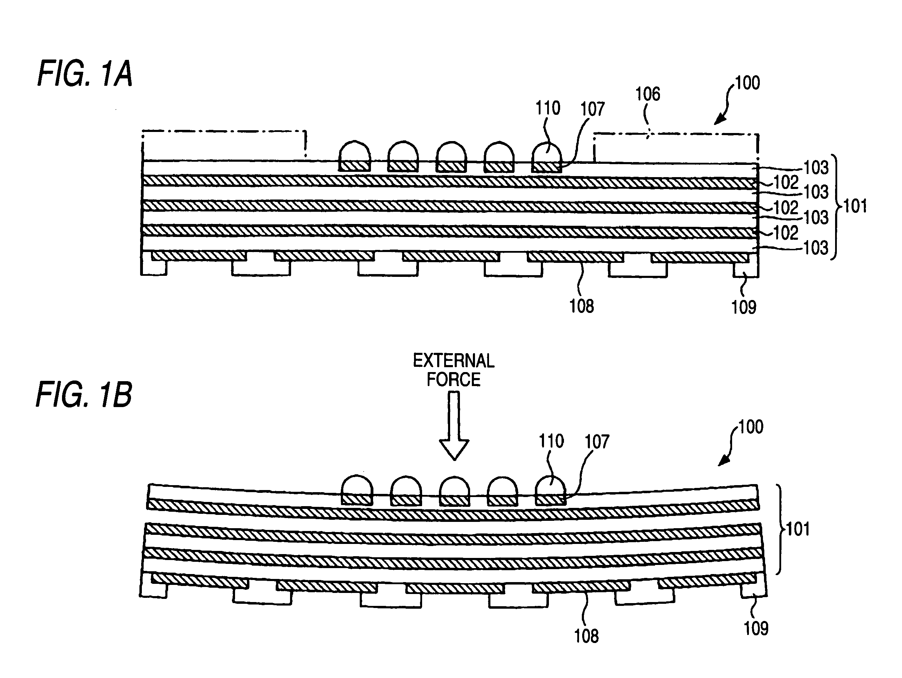

Fig. 1(A) shows one example of a wiring substrate manufactured by this manufacturing method. A wiring substrate 100 shown in Fig. 1(A) is constructed so that a wiring member 101 is formed by layering wiring layers 102 and insulating layers 103 and upper electrode pads 107 are formed on an upper part of the wiring member and also lower electrode pads 108 are formed on a lower part of the wiring member. Also, it is constructed so that solder bumps 110 are formed on the upper electrode pads 107 and also the lower electrode pads 108 are exposed from a solder resist 109 formed on a lower surface of the wiring member 101.

However, the wiring substrate 100 in which a support body is completely removed has a small mechanical strength of the substrate itself. Hence, there is a problem of easily deforming the wiring substrate 100 when external force is applied as shown in Fig. 1(B).

As a result of this, means in which a reinforcing member 106 is arranged by adhesion etc. so as to surround a formation region of the upper electrode pads 107 on the wiring member 101 and thereby a mechanical strength of the wiring substrate 100 is improved has been proposed as disclosed in Patent Reference 1 (the reinforcing member 106 is shown by a chain line in Fig. 1(A)).

[Patent Reference 1] JP-A-2000-323613

In the configuration fixed so as to stack the reinforcing member 106 on a surface of the wiring member 101 as described above, a thickness as a whole of the wiring substrate 100 increases and it cannot respond to the needs of thinning. Also, there is the reinforcing member 106 made of a metal material with a large shape on a surface of the wiring substrate 100, so that there is also a problem that the reinforcing member 106 may hinder mounting depending on a form of a semiconductor element mounted in the wiring substrate 100.

### SUMMARY OF THE INVENTION

The invention has been implemented in view of the problems described above, and an object of the invention is to provide a wiring substrate capable of improving a mechanical strength while achieving thinning, and a manufacturing method of the wiring substrate.
In light of the above, the wiring substrate according to independent claim 1, the manufacturing method according to independent claim 5, and the manufacturing method of claim 6 are provided.
Further advantages, features, aspects and details are evident from the dependent claims, the description and the drawings.

According to a first aspect of the invention, there is provided a wiring substrate including:
a wiring member made by layering an insulating layer and a wiring layer, and
a reinforcing body disposed between the insulating layers of the wiring member, wherein
the reinforcing body is configured to cross plural linear members.

According to a second aspect of the invention, there is provided the wiring substrate as in the first aspect, wherein
the reinforcing body is arranged in a center position with respect to a thickness direction of the wiring member.

According to a third aspect of the invention, there is provided the wiring substrate as in the first aspect, wherein
the reinforcing bodies are arranged with space upward and downward across a center position with respect to a thickness direction of the wiring member.

According to a forth aspect of the invention, there is provided the wiring substrate as in any one of the first to third aspects, wherein
the reinforcing body has a shape selected from at least a cross shape, an asterisk shape and a mesh shape in plan view.

According to a fifth aspect of the invention, there is provided a manufacturing method of a wiring substrate, including the steps of:
arranging a protective member in a reinforcing body configured to cross plural linear members,
forming an electrode on the protective member by a metal film,
forming a base half body by forming a first resin member to cover the reinforcing body and the protective member,
removing the protective member from the base half body and arranging a second resin material on a surface in which the protective member is removed,
forming an opening part for exposing the electrode in the first and second resin members,
forming a base body by forming a wiring metal layer on the inside of the opening part and surfaces of the first and second resin members, and
layering a wiring layer and an insulating layer on the base body to form a wiring member.

According to a sixth aspect of the invention, there is provided a manufacturing method of a wiring substrate, including the steps of:
layering a wiring layer and an insulating layer on a support body to form a wiring member,
removing the support body from the wiring member, and
disposing a reinforcing body configured to cross plural linear members on the insulating layer during formation of the wiring member, namely, after at least the wiring layer or the insulating layer is formed on the support body.

According to a seventh aspect of the invention, there is provided the manufacturing method of a wiring substrate as in the sixth aspect, wherein
the step of disposing the reinforcing body is performed plural times during formation of the wiring member, namely, after at least the wiring layer or the insulating layer is formed on the support body.

According to an eighth aspect of the invention, there is provided the manufacturing method of a wiring substrate as in the sixth aspect, wherein
the step of disposing the reinforcing body is performed one time in a case of forming the wiring member to half of the predetermined thickness during formation of the wiring member, namely, after at least the wiring layer or the insulating layer is formed on the support body.

According to a ninth aspect of the invention, there is provided the manufacturing method of a wiring substrate as in any one of the sixth to eighth aspects, wherein
the reinforcing body is provided on the insulating layer in the step of disposing the reinforcing body.
According to a tenth aspect of the invention, there is provided the manufacturing method of a wiring substrate as in any one of the sixth to eighth aspects, wherein
the step of disposing the reinforcing body includes processing for forming the reinforcing body on the insulating layer using a plating method.

According to the invention, by disposing a reinforcing body configured to cross plural linear members between the insulating layers of a wiring member, even when stress or external force is applied to a wiring substrate from various directions, the plural linear members subjected to the stress etc. are configured to be crossed, so that the stress etc. from all directions can be reduced. Also, weight reduction in the wiring substrate can be achieved as compared with a conventional flat plate-shaped reinforcing body.
An embodiment of the invention may be directed to a wiring substrate having a wiring member made by layering insulating layers and wiring layers, and a reinforcing body disposed between the insulating layers of this wiring member, this reinforcing body is configured to cross plural linear members.
Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Figs. 1(A) and 1(B) are diagrams describing a wiring substrate which is one conventional example and its problem.
Fig. 2 is a partially sectional view of a wiring substrate of a first embodiment of the invention.
Fig. 3 is a plan view of the wiring substrate of the first embodiment of the invention.
Figs. 4(A) to 4(D) are sectional views describing a manufacturing method of the wiring substrate of the first embodiment of the invention (first).
Figs. 5(A) to 5(E) are sectional views describing a manufacturing method of the wiring substrate of the first embodiment of the invention (second).
Figs. 6(A) to 6(C) are sectional views describing a manufacturing method of the wiring substrate of the first embodiment of the invention (third).
Fig. 7 is a partially sectional view of a wiring substrate of a second embodiment of the invention.
Figs. 8(A) to 8(C) are sectional views describing a manufacturing method of the wiring substrate of the second embodiment of the invention (first).
Figs. 9(A) to 9(D) are sectional views describing a manufacturing method of the wiring substrate of the second embodiment of the invention (second).
Figs. 10(A) to 10(C) are sectional views describing a manufacturing method of the wiring substrate of the second embodiment of the invention (third).
Fig. 11 is a partially sectional view of a wiring substrate of a third embodiment of the invention.
Figs. 12(A) and 12(B) are sectional views describing a manufacturing method of the wiring substrate of the third embodiment of the invention (first).
Figs. 13(A) to 13(D) are sectional views describing a manufacturing method of the wiring substrate of the third embodiment of the invention (second).
Fig. 14 is a partially sectional view of a wiring substrate of a fourth embodiment of the invention.
Figs. 15(A) to 15(D) are sectional views describing a manufacturing method of the wiring substrate of the fourth embodiment of the invention (first).
Figs. 16(A) to 16(D) are sectional views describing a manufacturing method of the wiring substrate of the fourth embodiment of the invention (second).
Figs. 17(A) to 17(C) are sectional views describing a manufacturing method of the wiring substrate of the fourth embodiment of the invention (third).
Figs. 18 (A) to 18 (C) are plan views of a wiring substrate using a reinforcing body which is a modified example of a reinforcing body used in the first embodiment.

### DETAILED DESCRIPTION OF THE PREFERRED EMBODIMENTS

Next, the best mode for carrying out the invention will be described together with the drawings.

### (First embodiment)

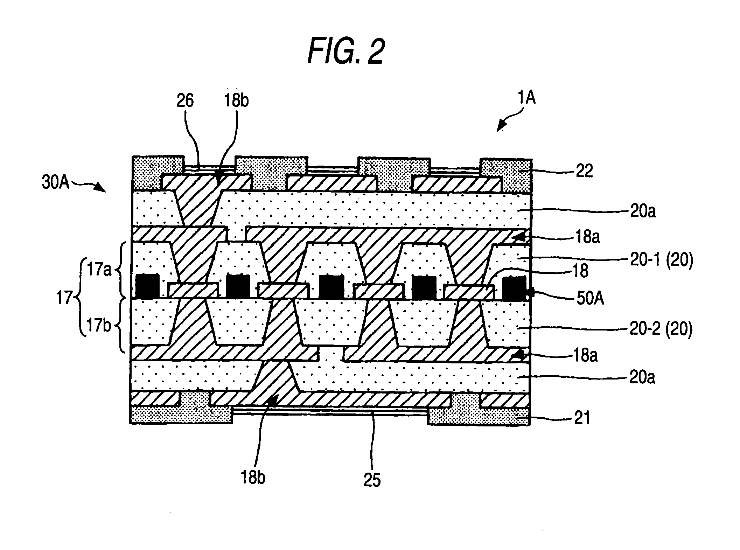

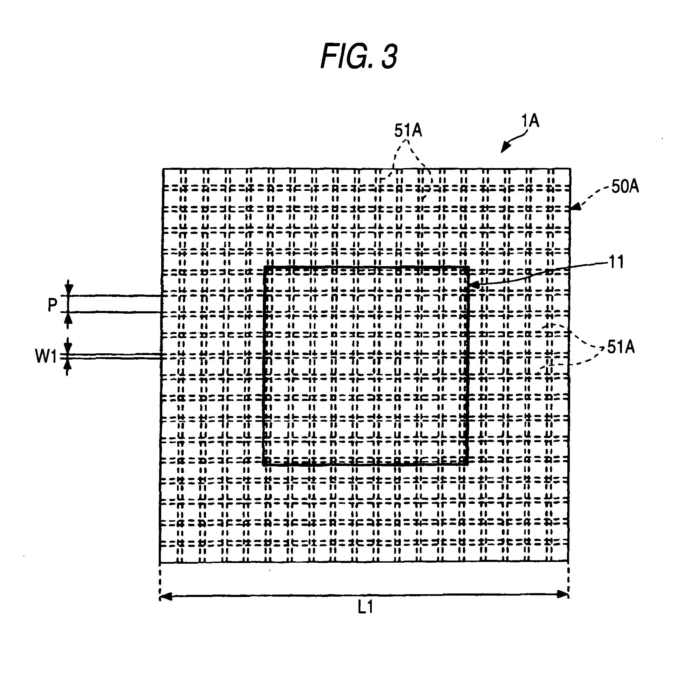

Figs. 2 and 3 show a wiring substrate 1A which is a first embodiment of the invention. Fig. 2 is a partially sectional view of the wiring substrate 1A, and Fig. 3 shows a state of viewing the wiring substrate 1A from the plane.

The wiring substrate 1A according to the present embodiment is broadly constructed of a wiring member 30A and a reinforcing body 50A. This wiring substrate 1A has a rectangular shape in which, for example, a length L1 (shown by an arrow in Fig. 3) of one side is 30 mm to 50 mm in plan view. For example, a semiconductor chip 11 (only the outline is shown in Fig. 3) is mounted in this wiring substrate 1A.
The wiring member 30A is constructed of a base body 17, a second wiring layer 18a, a third wiring layer 18b and solder resists 21, 22, etc. The base body 17 is disposed in substantially the center position of the wiring member 30A. This base body 17 is constructed of a base half body 17a located upward and a base half body 17b located downward.

The base half body 17a is constructed of an insulating layer half body 20-1 formed by a resin material such as an epoxy resin or a polyimide resin, the second wiring layer 18a and a first wiring layer 18 formed in this insulating layer half body 20-1. The first wiring layer 18 is formed in a position of bonding between the base half body 17a and the base half body 17b. Also, the second wiring layer 18a is constructed of a wiring part and a via part, and the via part is configured to be connected to the first wiring layer 18.

On the other hand, the base half body 17b is constructed of an insulating layer half body 20-2 formed by a resin material such as an epoxy resin or a polyimide resin and the second wiring layer 18a formed in this insulating layer half body 20-2. This second wiring layer 18a is constructed of a wiring part and a via part, and the via part is configured to be connected to the first wiring layer 18. Therefore, the second wiring layer 18a formed in the base half body 17a is configured to be electrically connected to the second wiring layer 18a formed in the base half body 17b through the first wiring layer 18.

A second insulating layer 20a, the third wiring layer 18b and the solder resists 21, 22, etc. are configured to be arranged in an upper part and a lower part of the base body 17 configured above. The second insulating layer 20a is formed by a resin material such as an epoxy resin or a polyimide resin and also, the third wiring layer 18b is formed by Cu (copper). This second insulating layer 20a and the third wiring layer 18b are respectively formed on both of upper and lower surfaces of the base body 17 using a build-up method as described below.

The solder resists 21, 22 cover the front of the wiring member 30A excluding the portion used as an external connection terminal of the third wiring layer 18b. Also, pad surface plated layers 25, 26 are formed in the portion exposed from the solder resist 22 of the third wiring layer 18b. The pad surface plated layers 25, 26 have a structure layered by being plated with Ni (nickel) and Au (gold).

The reinforcing body 50A is arranged in substantially the center position with respect to a thickness direction of the wiring member 30A. Concretely, the reinforcing body 50A is arranged in a state of being sandwiched between a pair of the insulating layer half bodies 20-1, 20-2 in a position of the boundary between the base half body 17a and the base half body 17b of the inside of the base body 17. This reinforcing body 50A is configured to cross plural linear members 51A with straight line shapes and have a mesh shape as a whole as shown in Fig. 3.

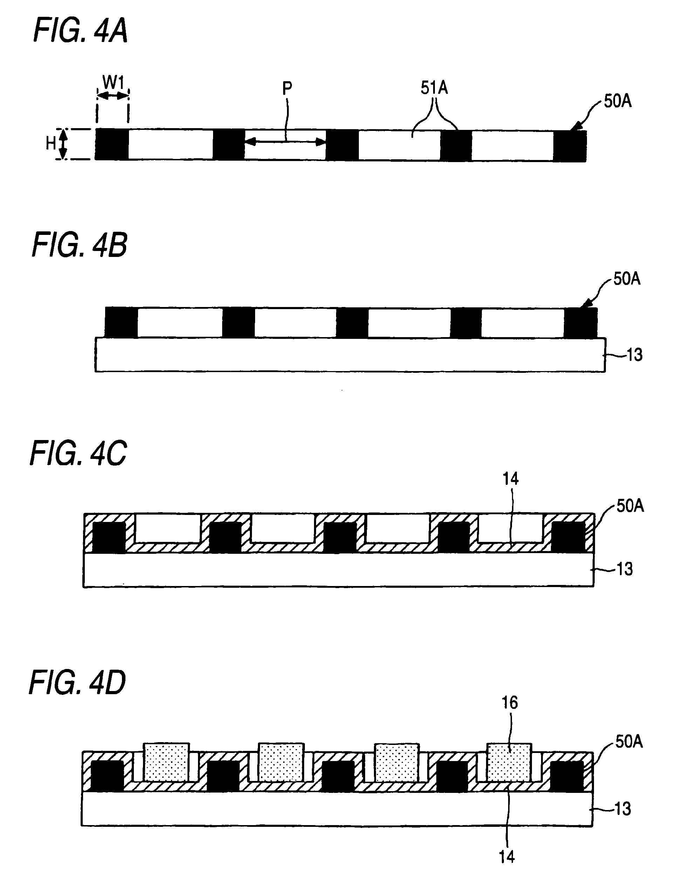

Metal, glass, silicon, ceramic, hard resin or a copper clad layered plate, etc. can be applied to each of the linear members 51A. Also, a width W1 and a height H (see Fig. 4 for the height H) of each of the linear members 51A can be selected in the range of 50 µm to 400 µm, and are preferably set at 100 µm in its range. Also, a pitch P between the adjacent linear members 51A can be selected in the range of 200 µm to 800 µm, and is preferably set at 500 µm in its range. In addition, in Fig. 3, the reinforcing body 50A is shown as a uniform mesh structure, but a mesh shape is properly deformed so as not to interfere with the first and second wiring layers 18, 18a.

According to the wiring substrate 1A according to the embodiment as described above, even when internal stress by application of heat occurs inside the wiring substrate 1A and also external force is applied to the wiring substrate 1A, the reinforcing body 50A is subjected to this stress or external force, and these forces are not applied to the insulating layers 20, 20a and the wiring layers 18, 18a, 18b.

Further, the reinforcing body 50A according to the embodiment has a beam structure in which the plural linear members 51A are crossed unlike a mesh into which fibers are woven. As a result of this, it can cope also with external force and stress from various directions and thus, the wiring substrate 1A can effectively be prevented from being deformed.

Also, the reinforcing body 50A according to the embodiment has a mesh shape in which multiple space parts are present in the inside, so that weight reduction in the wiring substrate can also be achieved as compared with a conventional frame-shaped reinforcing body.

Next, a manufacturing method of the wiring substrate 1A mentioned above will be described. Figs. 4 to 6 are views describing the manufacturing method of the wiring substrate 1A of the first embodiment of the invention.

In the case of manufacturing the wiring substrate 1A, a reinforcing body 50A is first prepared as shown in Fig. 4 (A) . This reinforcing body 50A has the mesh shape as described above and is formed by metal, glass, silicon, ceramic, etc. In addition, the reinforcing body 50A used in the embodiment is a reinforcing body previously manufactured in a manufacturing step different from a manufacturing step of a wiring substrate 1A.

As shown in Fig. 4(B), a protective tape 13 is arranged on this reinforcing body 50A. This protective tape 13 is, for example, a resin tape to which an adhesive is applied and a thickness of the tape is, for example, 100 µm.

Next, as shown in Fig. 4(C), Cu foil 14 (a metal film described in the claim) is arranged on a surface of the protective tape 13. This Cu foil 14 has, for example, a thickness of 18 µm and is stuck on an upper surface of the protective tape 13 and a surface of the reinforcing body 50A using a vacuum laminate method.

Then, as shown in Fig. 4(D), a resist material 16 is formed on a formation position of a first wiring layer 18 described below of the Cu foil 14. In the case of forming this resist material 16, the resist material 16 is formed by first arranging a dry film on the upper surface of the protective tape 13 and patterning this dry film. In addition, it may be constructed so that an opening part is previously formed excluding the formation position of the first wiring layer 18 with respect to a dry filmy resist film and this is arranged on the protective tape 13.

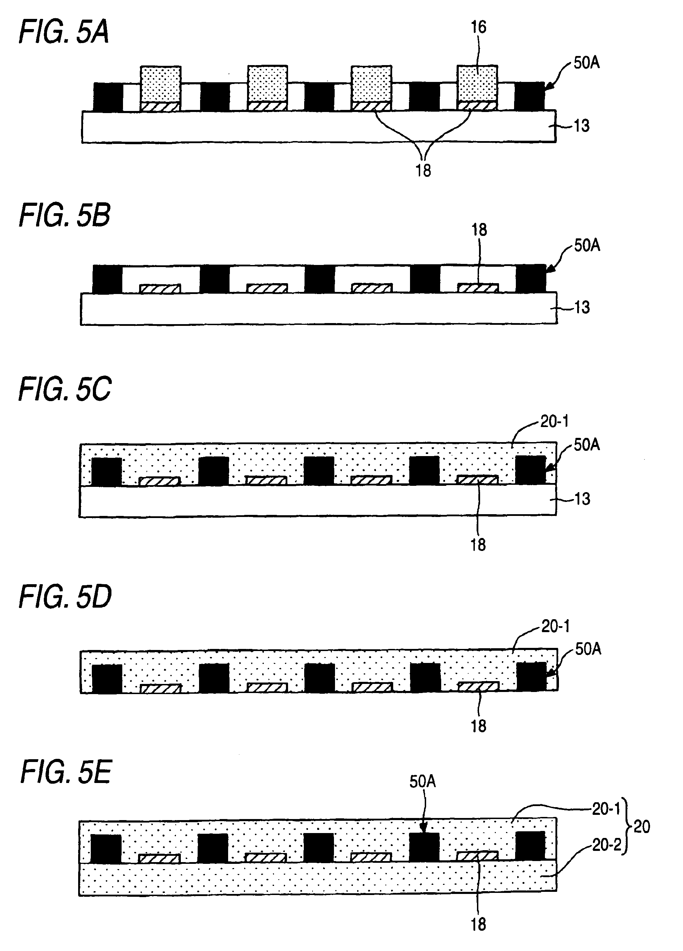

Then, as shown in Fig. 5(A), etching processing is performed with respect to the Cu foil 14 using the resist material 16 as a mask. When this etching processing is ended, the resist material 16 is removed and thereby the first wiring layer 18 is formed as shown in Fig. 5(B).

When the first wiring layer 18 is formed on the protective tape 13 thus, an insulating layer half body 20-1 is formed on the protective tape 13 so as to cover the first wiring layer 18 and the reinforcing body 50A as shown in Fig. 5(C).

As a material of this insulating layer half body 20-1, a resin material such as an epoxy resin or a polyimide resin is used. Also, as one example of a formation method of the insulating layer half body 20-1, the insulating layer half body 20-1 can be obtained by thermally treating a resin film at temperatures of 130 to 150 °C and curing the resin film while pressing (pressing) the resin film after the resin film is laminated to the protective tape 13.

When the insulating layer half body 20-1 is formed as described above, the protective tape 13 is peeled from the insulating layer half body 20-1 as shown in Fig. 5 (D). In this case, the first wiring layer 18 and the reinforcing body 50A are configured to be buried inside the insulating layer half body 20-1, so that the first wiring layer 18 and the reinforcing body 50A are not peeled together with this protective tape 13 even when the protective tape 13 is peeled.

Subsequently, as shown in Fig. 5(E), an insulating layer half body 20-2 is arranged on a lower surface of the insulating layer half body 20-1. As a material of this insulating layer half body 20-2, a resin material such as an epoxy resin or a polyimide resin can be used in a manner similar to the insulating layer half body 20-1. Also, the insulating layer half body 20-2 can be formed by the same formation method as that of the insulating layer half body 20-1 and concretely, the insulating layer half body 20-2 can be obtained by thermally treating a resin film at temperatures of 130 to 150 °C and curing the resin film while pressing (pressing) the resin film after the resin film is laminated to the insulating layer half body 20-1. Consequently, a first insulating layer 20 made of the insulating layer half body 20-1 and the insulating layer half body 20-2 is formed.

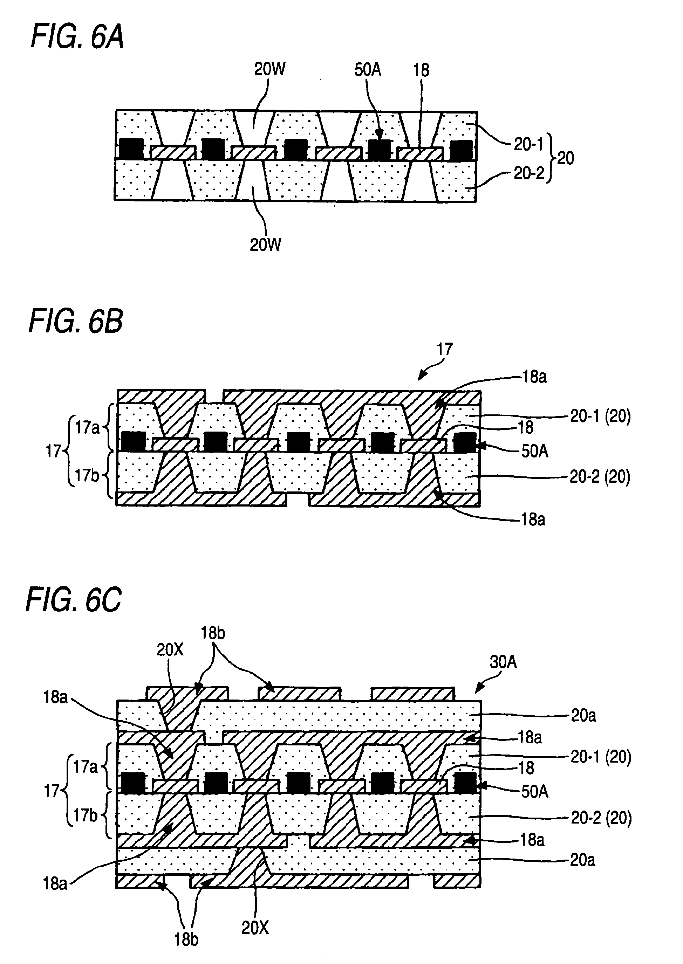

When the first insulating layer 20 is formed as described above, first via holes 20W are formed in the first insulating layer 20 so as to expose a connection pad 18 using a laser processing method etc. Formation of the first via holes 20W by this laser processing is implemented with respect to both of the insulating layer half body 20-1 and the insulating layer half body 20-2. As a result of this, the first wiring layer 18 is in a state of being exposed from the first insulating layer 20 in both of the upper and lower surfaces as shown in Fig. 6(A).

Subsequently, formation processing of a second wiring layer 18a is performed with respect to the first insulating layer 20 using a semi-additive method. Concretely, after cleaning by performing desmear processing with respect to the first via holes 20W, electroless Cu plating is performed on an upper surface of the first insulating layer 20 and inner surfaces of the first via holes 20W and thereby, a seed layer is formed. Subsequently, patterning is performed so as to leave the portion other than a formation position of the first wiring layer 18a while arranging a resist material.

Then, the second wiring layer 18a is formed by performing electrolytic plating of Cu using the seed layer as a power feeding layer. When the second wiring layer 18a is formed in this manner, the resist material and the seed layer are removed and thereby a base body 17 shown in Fig. 6 (B) is formed. The base body 17 formed in this manner has a structure of bonding a base half body 17a in which the reinforcing body 50A, the first wiring layer 18 and the second wiring layer 18a are formed inside the insulating layer half body 20-1 to a base half body 17b in which the second wiring layer 18a is formed in the insulating layer half body 20-2.

When the base body 17 is formed as described above, second insulating layers 20a and third wiring layers 18b are formed on upper and lower surfaces of this base body 17. The second insulating layers 20a and the third wiring layers 18b are formed using a build-up method and a semi-additive method.

Concretely, the second insulating layers 20a are formed on both surfaces of the base body 17 and second via holes 20X are formed in formation positions of vias with respect to the second insulating layers 20a by laser processing. Next, after desmear processing is performed with respect to the second via holes 20X, electroless Cu plating is performed on a surface of the second insulating layer 20a and inner surfaces of the second via holes 20X and thereby, a seed layer is formed. Subsequently, patterning is performed so as to leave the portion other than a formation position of the third wiring layer 18b while arranging a resist material.

Then, the third wiring layer 18b is formed by performing electrolytic plating of Cu using the seed layer as a power feeding layer. When the third wiring layer 18b is formed in this manner, the resist material and the seed layer are removed and thereby a wiring member 30A shown in Fig. 6 (C) is formed. Subsequently, the wiring substrate 1A shown in Fig. 2 is manufactured by forming a solder resist 22 and pad surface plated layers 25, 26. In addition, in the example described above, the build-up wiring layer with a total of four layers is formed, but a build-up wiring layer with n layers (n is an integer of one or more) may be formed.

According to the manufacturing method described above, each of the insulating layers 20, 20a and each of the wiring layers 18, 18a, 18b are formed around an arrangement position of the reinforcing body 50A, so that vertical balance around the reinforcing body 50A improves and occurrence of internal stress can be suppressed. Also, the reinforcing body 50A is constructed by only one layer of the center, so that a member cost can be reduced.

### (Second embodiment)

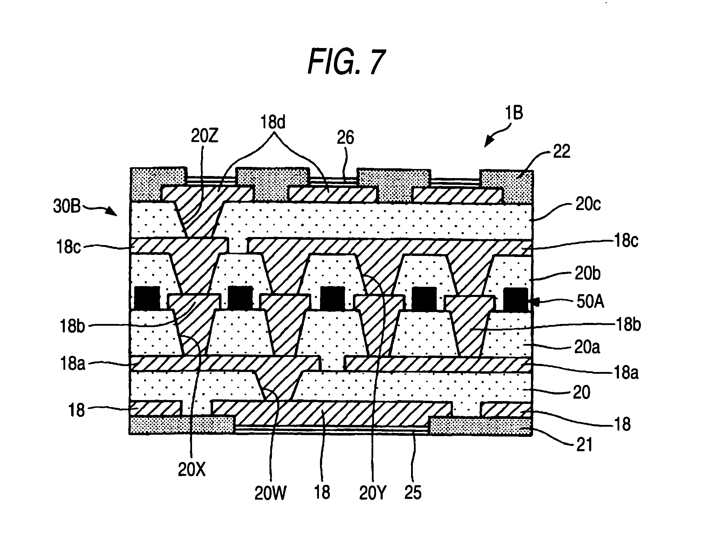

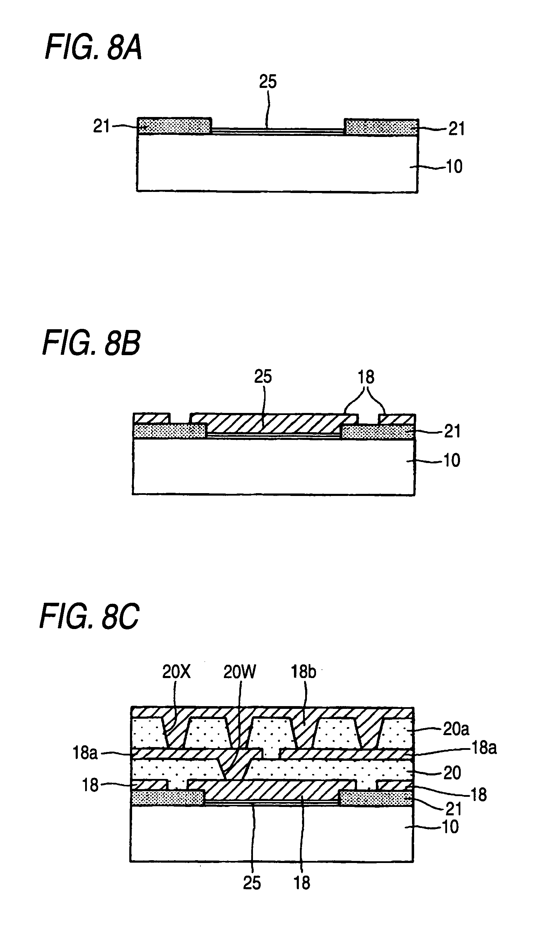

Next, a second embodiment of the invention will be described. Fig. 7 is a sectional view showing a wiring substrate 1B which is the second embodiment, and Figs. 8 to 10 show a manufacturing method of the wiring substrate 1B. In addition, in Figs. 8 to 10, the description shall properly be omitted by assigning the same numerals to configurations corresponding to the configurations shown in Figs. 2 to 6 used in the description of the first embodiment.

Since the wiring substrate 1A according to the first embodiment described above is configured to form each of the insulating layers 20, 20a and each of the wiring layers 18, 18a, 18b around an arrangement position of the reinforcing body 50A, shapes of via parts formed in each of the wiring layers 18, 18a, 18b are also formed in the shapes layered symmetrically around the arrangement position of the reinforcing body 50A.

On the other hand, the wiring substrate 1B according to the present embodiment is characterized in that each of the insulating layers 20, 20a, 20b, 20c and wiring layers 18, 18a, 18b, 18c, 18d are sequentially layered and formed from the first insulating layer 20 toward the fourth insulating layer 20c. As a result of this, a shape of a via part formed in each of the wiring layers 18a, 18b, 18c, 18d is formed in the same direction.

However, also in the wiring substrate 1B according to the embodiment, a reinforcing body 50A is arranged in a center position of a wiring member 30B in a manner similar to the wiring substrate 1A according to the first embodiment, so that the wiring member 30B can surely be reinforced and even when stress or external force is applied from various directions, the wiring substrate 1B can effectively be prevented from being deformed and also weight reduction in the wiring substrate 1B can be achieved. Also, wiring members with the same configuration can be formed on both surfaces of a support body 10, so that productivity can be improved.

Next, a manufacturing method of the wiring substrate 1B configured as mentioned above will be described.

In the case of manufacturing the wiring substrate 1B, a support body 10 is first prepared as shown in Fig. 8 (A). In the embodiment, copper foil is used as the support body 10. A thickness of this copper foil is, for example, 35 to 100 µm.

A solder resist 21 and a pad surface plated layer 25 are formed on this support body 10. In the solder resist 21, an opening part is formed in a predetermined position and the pad surface plated layer 25 is formed inside this opening part. This pad surface plated layer 25 has a structure of layering an Au film, a Pd film and an Ni film, and can be formed using, for example, a plating method or a sputtering method.

A resist film (not shown) is formed on this support body 10 and also patterning processing is performed with respect to this resist film and an opening part is formed in a position corresponding to a formation position of a connection pad 18. Next, a first wiring layer 18 is formed on the support body 10 by electrolytic plating of Cu using the support body 10 in a plated power feeding layer. In this case, the first wiring layer 18 is also formed on the pad surface plated layer 25. Subsequently, by removing the resist film, the first wiring layer 18 with a predetermined shape is formed on the support body 10 as shown in Fig. 8(B). In addition, this connection pad 18 functions as an external connection terminal of the wiring substrate 1B.

Subsequently, a first insulating layer 20 for covering the connection pad 18 is formed in the support body 10. As a material of this first insulating layer 20, a resin material such as an epoxy resin or a polyimide resin is used. As one example of a formation method of the first insulating layer 20, the first insulating layer 20 can be obtained by thermally treating a resin film at temperatures of 130 to 150 °C and curing the resin film while pressing (pressing) the resin film after the resin film is laminated to the support body 10.

Then, a first via hole 20W is formed in the first insulating layer 20 formed in the support body 10 so as to expose the connection pad 18 using a laser processing method etc. Subsequently, a second wiring layer 18a connected to the connection pad 18 formed on the support body 10 through the first via hole 20W is formed. This second wiring layer 18a is made of copper (Cu) and is formed on the first insulating layer 20. This second wiring layer 18a is formed by, for example, a semi-additive method.

Concretely, first, a resist film including an opening part corresponding to the second wiring layer 18a is formed after a Cu seed layer is formed on an upper surface of the first insulating layer 20 and the first via hole 20W by electroless plating or a sputtering method. Next, a Cu layer pattern is formed in an opening part of the resist film by electrolytic plating using the Cu seed layer in a plated power feeding layer.

Subsequently, the second wiring layer 18a is obtained by etching the Cu seed layer using the Cu layer pattern as a mask after the resist film is removed. In addition, various wiring formation methods such as a subtractive method in addition to the semi-additive method described above can be adopted as a formation method of the second wiring layer 18a.

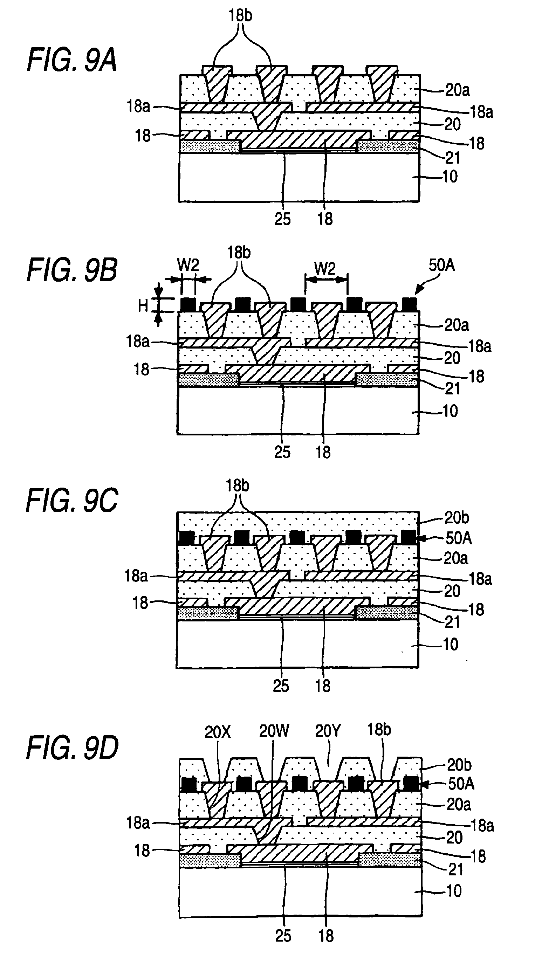

Then, a second via hole 20X is formed in the portion of a second insulating layer 20a on the second wiring layer 18a after the second insulating layer 20a for covering the second wiring layer 18a is formed in the support body 10 by repeating steps similar to the above. Further, a third wiring layer 18b connected to the second wiring layer 18a through the second via hole 20X is formed on the second insulating layer 20a of the support body 10. Fig. 9(A) shows the support body 10 in which the third wiring layer 18b is formed.

A state of forming this third wiring layer 18b is a state of forming a wiring member 30B to about half the thickness with respect to a thickness direction of the wiring member 30B. When the wiring member 30B is formed to about half the thickness with respect to its thickness direction thus, a reinforcing body 50A is subsequently installed on an upper surface of the second insulating layer 20a.

In addition, in the embodiment, the reinforcing body 50A is a reinforcing body previously manufactured in a manufacturing step different from a manufacturing step of the wiring substrate 1B. This reinforcing body 50A is temporarily joined to an upper part of the second insulating layer 20a using an adhesive.

Also, it is necessary to place the reinforcing body 50A on the second insulating layer 20a so as not to interfere with the third wiring layer 18b. As a result of this, it may be constructed so that a guide pin (not shown) for positioning is previously disposed and thereby the reinforcing body 50A is placed on the second insulating layer 20a with high accuracy.

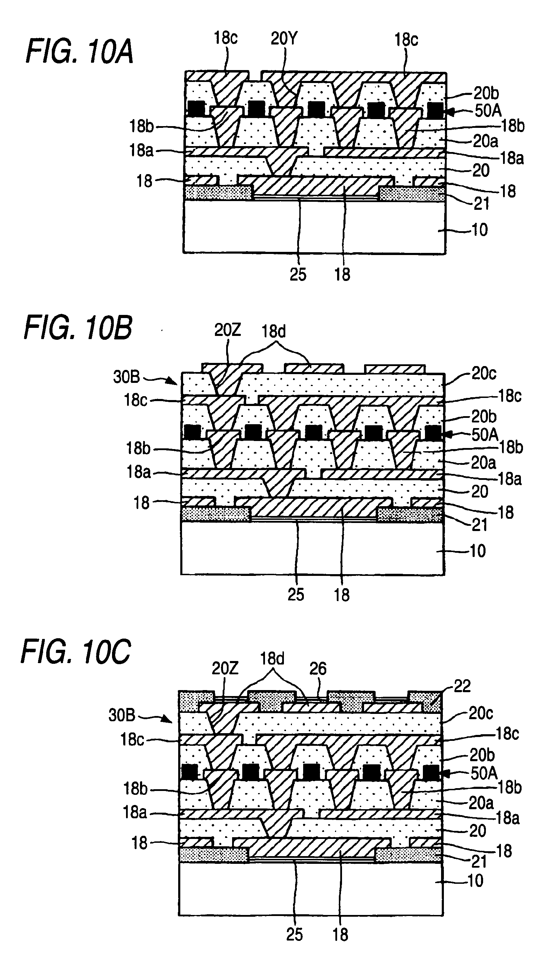

When the reinforcing body 50A is attached as described above, a third insulating layer 20b is formed in the support body 10 so as to cover the reinforcing body 50A and the third wiring layer 18b as shown in Fig. 9(C). Thereafter, as shown in Fig. 9 (D), a third via hole 20Y communicating with the third wiring layer 18b is formed in a predetermined portion of the third insulating layer 20b on the third wiring layer 18b by laser processing. Subsequently, as shown in Fig. 10(A), a fourth wiring layer 18c connected to the third wiring layer 18b through the third via hole 20Y is formed on the third insulating layer 20b.

When the fourth wiring layer 18c is formed as described above, a fourth insulating layer 20c is formed so as to cover this fourth wiring layer 18c. Thereafter, a fourth via hole 20Z communicating with the fourth wiring layer 18c is formed in a predetermined portion of the fourth insulating layer 20c on the fourth wiring layer 18c by laser processing. Subsequently, as shown in Fig. 10 (B), a fifth wiring layer 18d connected to the fourth wiring layer 18c through the fourth via hole 20Z is formed on the fourth insulating layer 20c. The wiring member 30B is formed by passing through the steps described above.

In addition, in the example described above, the build-up wiring layer with five layers (first to fifth wiring layers 18 to 18d) is formed, but a build-up wiring layer with n layers (n is an integer of one or more) may be formed.

When the wiring member 30B is formed as described above, a solder resist 22 in which an opening part is disposed in a predetermined position is formed on the fourth insulating layer 20c as shown in Fig. 10 (C) . The fifth wiring layer 18d exposed to the inside of the opening part of this solder resist 22 results in an external connection terminal. A pad surface plated layer 26 is formed on a surface of the fifth wiring layer 18d exposed from this opening part. This pad surface plated layer 26 has the same configuration as that of the pad surface plated layer 25 described above.

Then, the support body 10 functioning as the support body is removed. This support body 10 can be removed by wet etching using a ferric chloride aqueous solution, a cupric chloride aqueous solution or an ammonium persulfate aqueous solution, etc. In this case, in the connection pad 18, the pad surface plated layer 25 is formed on the uppermost surface, so that the support body 10 can be selectively etched and removed with respect to the first wiring layer 18 and the first insulating layer 20. Consequently, the wiring substrate 1B shown in Fig. 7 is manufactured.

According to the manufacturing method described above, each of the insulating layers 20, 20a, 20b, 20c and each of the wiring layers 18, 18a, 18b, 18c, 18d are layered on the robust support body 10, so that each of the insulating layers and the wiring layers can be formed with high accuracy and also the reinforcing body 50A can be installed in a proper position. Consequently, interference between the reinforcing body 50A and the third and fourth wiring layers 18b, 18c can be prevented and the wiring substrate 1B can be manufactured with high reliability.

Also, in the embodiment described above, the manufacturing method and the configuration in which the wiring member 30B is formed on one surface of the support body 10 is shown, but the wiring members 30B in which the reinforcing bodies 50A are disposed can also be formed on both surfaces of the support body 10. In the case of using this configuration, two wiring substrates 1B can be manufactured using one support body 10, so that manufacturing efficiency can be improved.

### (Third embodiment)

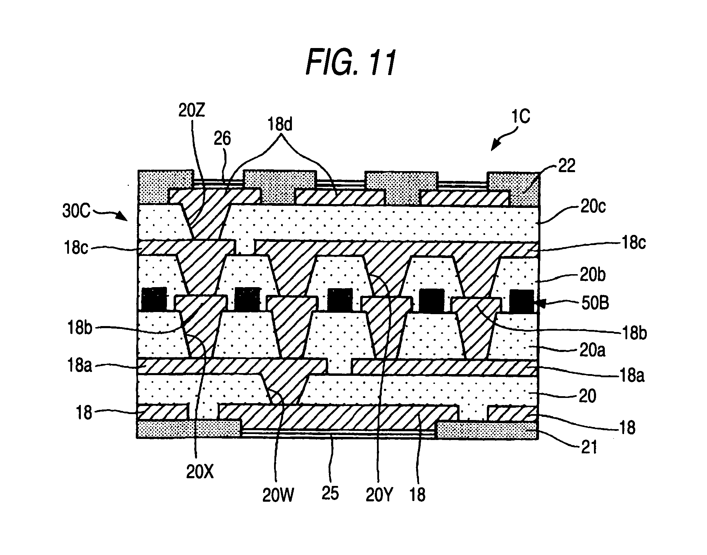

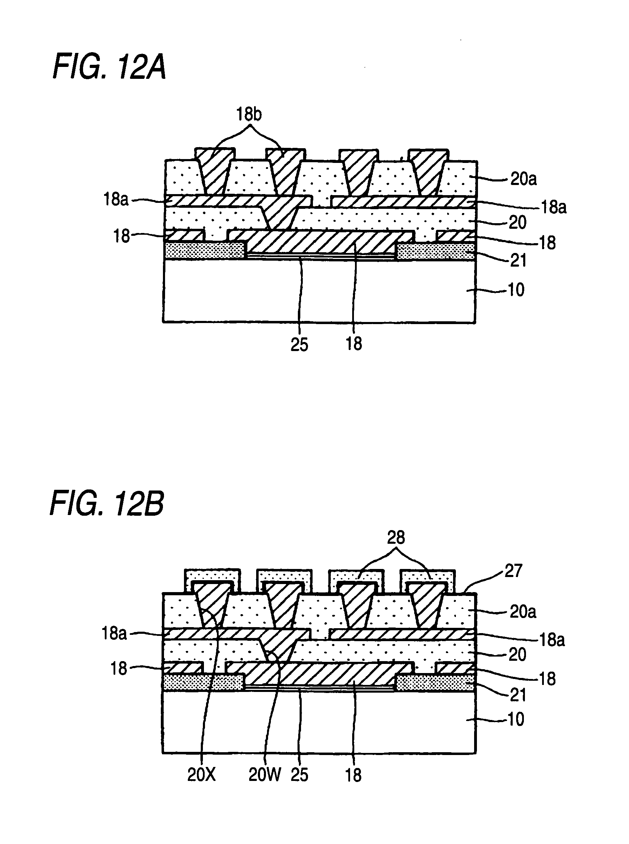

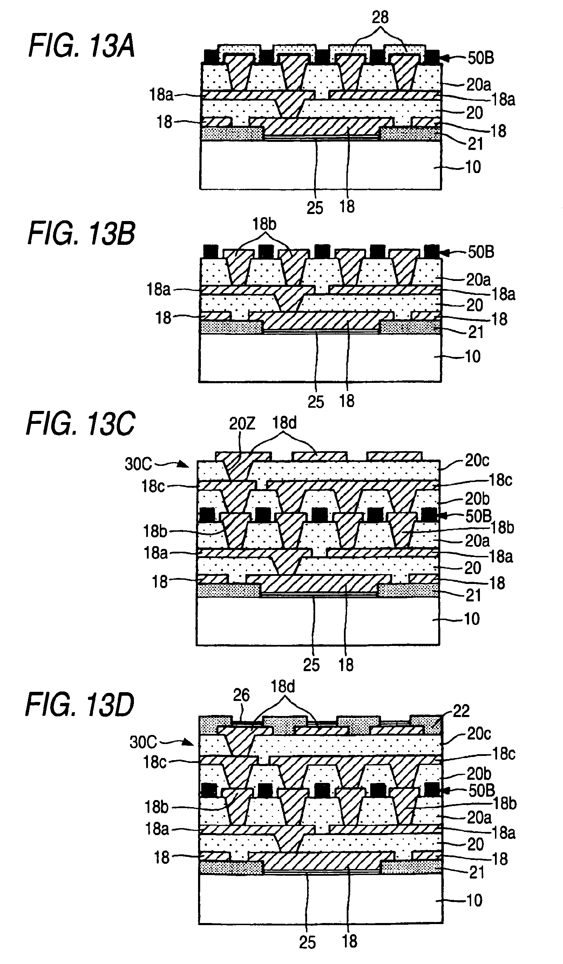

Next, a third embodiment of the invention will be described. Fig. 11 is a sectional view showing a wiring substrate 1C which is the third embodiment, and Figs. 12 and 13 show a manufacturing method of the wiring substrate 1C. In addition, in Figs. 11 to 17 used in each of the embodiments described below, the description shall properly be omitted by assigning the same numerals to configurations corresponding to the configurations shown in Figs. 7 to 10 used in the description of the second embodiment.

The wiring substrate 1B according to the second embodiment described above is configured to use the reinforcing body 50A manufactured in a step different from the manufacturing step of the wiring substrate 1B. On the other hand, the present embodiment is characterized in that a reinforcing body 50B is simultaneously formed inside a manufacturing step of the wiring substrate 1C. Because of this, in the wiring substrate 1C according to the embodiment, the reinforcing body 50B is formed by Cu which is the same material as that of a wiring layer.

Even when the reinforcing body 50B is formed by the same material as that of the wiring layer thus, this reinforcing body 50B is configured to cross plural linear members and thereby, a wiring member 30C can surely be reinforced and even when stress or external force is applied from various directions, the wiring substrate 1C can effectively be prevented from being deformed and further weight reduction in the wiring substrate 1C can be achieved. Also, by preventing the occurrence of deformation as described above, handling of the wiring substrate 1C is facilitated and thus, the occurrence of breakage or a crack at the time of handling can be prevented.

Next, a manufacturing method of the wiring substrate 1C configured as mentioned above will be described.

In the case of manufacturing the wiring substrate 1C, the manufacturing method previously described using Figs. 8 (A) to 8(C) and Fig. 9(A) is similar in the embodiment, so that the description is omitted. Fig. 12(A) is equivalent to the view shown in Fig. 9(A). Hence, the subsequent manufacturing steps shall be described.

A seed layer 27 made of Cu is formed on an upper surface of a second insulating layer 20a and an upper surface of a third wiring layer 18b when the third wiring layer 18b is formed in the second insulating layer 20a as shown in Fig. 12(A). Subsequently, a resist material is formed in an upper part on which the seed layer 27 is formed and also, patterning for removing the portion excluding a formation position of a reinforcing body 50B is performed. Fig. 12 (B) shows a resist material 28 in which the patterning is performed. This resist material 28 is formed so as to cover the third wiring layer 18b.

When the resist material 28 is formed, electrolytic plating of Cu is subsequently performed using the seed layer 27 as a power feeding layer. Consequently, the reinforcing body 50B is formed between each of the resist materials 28. In addition, in the embodiment, Cu is used as a material of the reinforcing body 50B, so that the electrolytic plating of Cu is performed, but when another material (for example, Ni) is used as the material of the reinforcing body 50B, electrolytic plating by the material (Ni) is performed.

When the reinforcing body 50B is formed on an upper part of the second insulating layer 20a as described above, the resist material 28 is removed. Fig. 13(B) shows a state of removing the resist material 28.

After the reinforcing body 50B is formed thus, the same steps as those described using Figs. 9(C), 9 (D) and Figs. 10 (A) to 10(C) in the second embodiment are performed and thereby, the wiring substrate 1C shown in Fig. 11 is manufactured. In addition, Fig. 13 (C) corresponds to Fig. 10 (B), and Fig. 13 (D) corresponds to Fig. 10(C).

According to the manufacturing method described above, the reinforcing body 50B can be formed collectively in a step of building up each of the insulating layers 20, 20a, 20b, 20c and each of the wiring layers 18, 18a, 18b, 18c, 18d, so that the wiring substrate 1C having the reinforcing body 50B can be manufactured easily at low cost. Also, a shape of the reinforcing body 50B can be changed relatively easily by properly changing the patterning of the resist material 28. Also, unlike the other embodiments described above, a step of mounting the reinforcing body is absent, so that the reinforcing body 50B can be formed by appropriating the existing process apparatus of build-up.

### (Fourth embodiment)

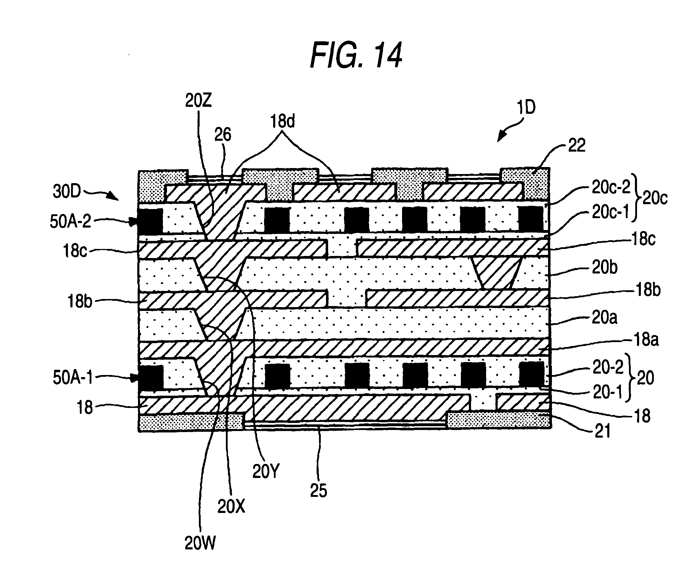

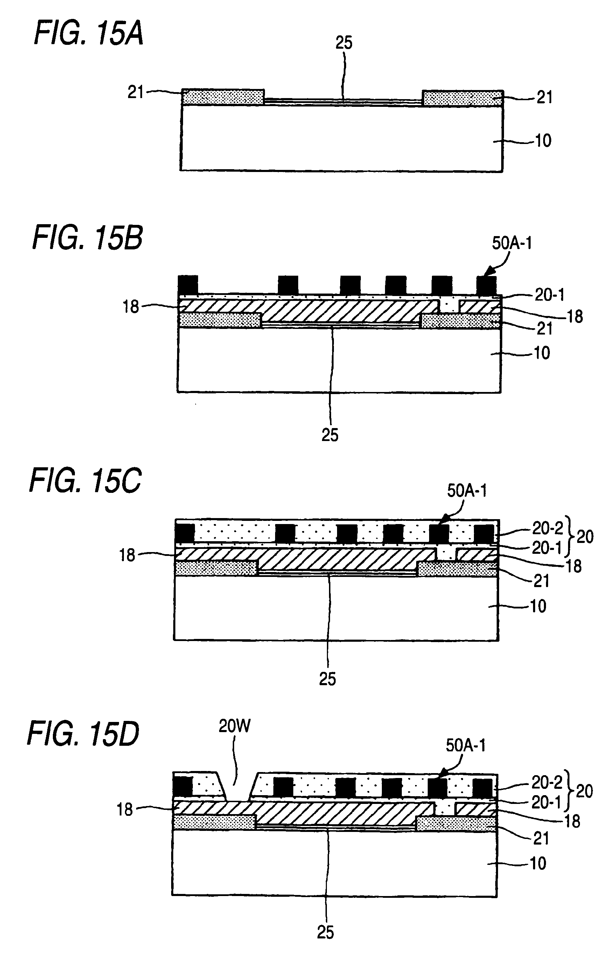

Next, a fourth embodiment of the invention will be described. Fig. 14 is a sectional view showing a wiring substrate 1D which is the fourth embodiment, and Figs. 15 to 17 show a manufacturing method of the wiring substrate 1D.

The wiring substrates 1B, 1C according to the second and third embodiments described above are configured to form the reinforcing bodies 50A, 50B in the center positions of the wiring members 30B, 30C. As a result of this, in the manufacturing steps of the wiring substrates 1B, 1C, the step of arranging the reinforcing bodies 50A, 50B is performed only one time.

On the other hand, the wiring substrate 1D according to the present embodiment is characterized by having a configuration in which a reinforcing body 50A-1 and a reinforcing body 50A-2 are arranged with space upward and downward across a center position with respect to a thickness direction of a wiring member 30D. Therefore, in a manufacturing step of the wiring substrate 1D, processing for installing the reinforcing body is performed plural times (two times in the embodiment).

In the wiring substrate 1D according to the embodiment, the plural reinforcing body 50A-1 and reinforcing body 50A-2 are present inside the wiring member 30D, so that deformation of the wiring substrate 1D resulting from stress or external force can be prevented more surely.

Next, a manufacturing method of the wiring substrate 1D configured as mentioned above will be described.

In the case of manufacturing the wiring substrate 1D, a support body 10 is first prepared as shown in Fig. 15(A). In the embodiment, copper foil is used as the support body 10. A solder resist 21 and a pad surface plated layer 25 are formed on the support body 10 in a manner similar to that described in the second embodiment.

A first wiring layer 18 is formed on this support body 10 by a method similar to that described in the second and third embodiments. Subsequently, an insulating layer half body 20-1 is formed in an upper part of the support body 10 on which this first wiring layer 18 is formed. This insulating layer half body 20-1 has the same material as the material of the insulating layer used in each of the embodiments described above, and a resin material such as an epoxy resin or a polyimide resin is used.

When the insulating layer half body 20-1 is formed thus, a first reinforcing body 50A-1 is installed on an upper part of this insulating layer half body 20-1 as shown in Fig. 15 (B) . This first reinforcing body 50A-1 has the same configuration as that of the reinforcing body 50A used in the first and second embodiments described above. This reinforcing body 50A-1 is temporarily joined on the insulating layer half body 20-1 using an adhesive. Also, it may be configured to be positioned using a guide pin as described above in the case of this temporary joint.

When the reinforcing body 50A-1 is installed on the insulating layer half body 20-1, an insulating layer half body 20-2 is subsequently formed on the insulating layer half body 20-1 so as to cover the reinforcing body 50A-1. This insulating layer half body 20-2 also has a resin material such as an epoxy resin or a polyimide resin, and can be formed by thermally treating a resin film at temperatures of 130 to 150 °C and curing the resin film while pressing (pressing) the resin film after the resin film made of the resin material is laminated to the insulating layer half body 20-1. In this case, the insulating layer half body 20-1 is integrated with the insulating layer half body 20-2 and hence, a first insulating layer 20 is formed as shown in Fig. 15(C).

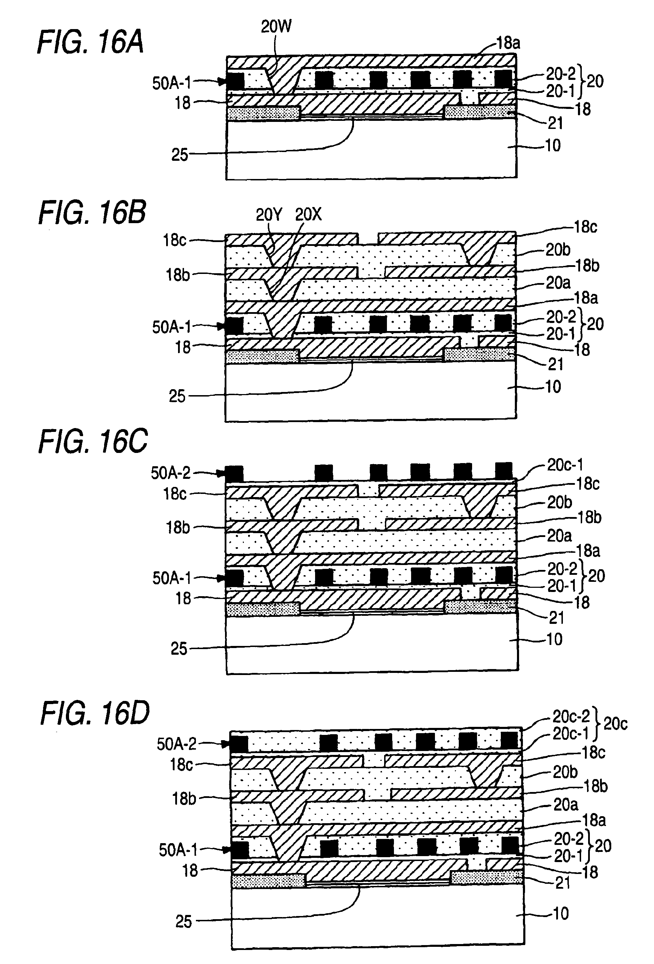

Then, as shown in Fig. 15(D), a first via hole 20W is formed in the first insulating layer 20 so as to expose a connection pad 18 using a laser processing method etc. Subsequently, a second wiring layer 18a connected to the connection pad 18 formed on the support body 10 through the first via hole 20W is formed using the semi-additive method described above. Fig. 16(A) shows a state of forming the second wiring layer 18a.

Then, by repeating steps similar to those described above (build-up step and semi-additive step), a second insulating layer 20a, a third wiring layer 18b, a third insulating layer 20b and a fourth wiring layer 18c are formed on an upper part of the second wiring layer 18a. Fig. 16(B) shows a state of layering and forming each of the insulating layers 20, 20a, 20b and each of the wiring layers 18, 18a, 18b, 18c.

Subsequently, an insulating layer half body 20c-1 is formed in an upper part of the third insulating layer 20b on which this fourth wiring layer 18c is formed. This insulating layer half body 20c-1 also has the same material as the material of the insulating layer used in each of the embodiments described above, and a resin material such as an epoxy resin or a polyimide resin is used. Also, it is desirable to set a thickness of this insulating layer half body 20c-1 at about 10 µm in a manner similar to the insulating layer half body 20-1.

When the insulating layer half body 20c-1 is formed thus, a second reinforcing body 50A-2 is installed on an upper part of this insulating layer half body 20c-1 as shown in Fig. 16 (C) . This second reinforcing body 50A-2 also has the same configuration as that of the reinforcing body 50A used in the first and second embodiments described above. This reinforcing body 50A-2 is temporarily joined on the insulating layer half body 20c-1 using an adhesive. Also, it may be configured to be positioned using a guide pin as described above in the case of this temporary joint.

When the reinforcing body 50A-2 is installed on the insulating layer half body 20c-1, an insulating layer half body 20c-2 is subsequently formed on the insulating layer half body 20c-1 so as to cover the reinforcing body 50A-2. This insulating layer half body 20c-2 also has a resin material such as an epoxy resin or a polyimide resin, and is formed in a manner similar to that of the insulating layer half body 20-2. Consequently, the insulating layer half body 20c-1 is integrated with the insulating layer half body 20c-2 and hence, a fourth insulating layer 20c is formed as shown in Fig. 16(D).

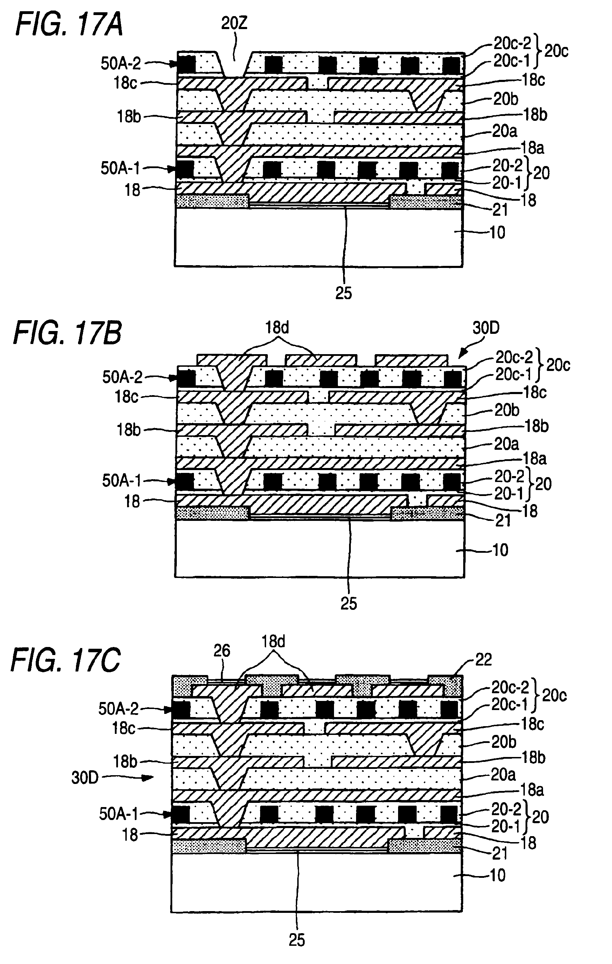

Then, as shown in Fig. 17(A), a fourth via hole 20Z is formed in the fourth insulating layer 20c so as to expose the fourth wiring layer 18c using a laser processing method etc. Subsequently, a fifth wiring layer 18d connected to the fourth wiring layer 18c through the fourth via hole 20Z is formed using the semi-additive method described above. Fig. 17(B) shows a state of forming the fifth wiring layer 18d. The wiring member 30D is formed by passing through the steps described above.

In addition, in the embodiment, the build-up wiring layer with five layers (first to fifth wiring layers 18 to 18d) is formed, but a build-up wiring layer with n layers (n is an integer of one or more) may be formed.

When the wiring member 30D is formed as described above, a solder resist 22 in which an opening part is disposed in a predetermined position is formed on the fourth insulating layer 20c as shown in Fig. 17 (C) . The fifth wiring layer 18d exposed to the inside of the opening part of this solder resist 22 results in an external connection terminal. A pad surface plated layer 26 is formed on a surface of the fifth wiring layer 18d exposed from this opening part. This pad surface plated layer 26 has the same configuration as that of the pad surface plated layer 25 described above.

Then, the support body 10 functioning as the support body is removed in a manner similar to the second and third embodiments described above. Consequently, the wiring substrate 1D shown in Fig. 14 is manufactured.

According to the manufacturing method described above, the plural reinforcing bodies 50A-1, 50A-2 can easily be incorporated into the wiring member 30D and the wiring substrate 1D capable of effectively preventing occurrence of deformation can easily be manufactured.

The preferred embodiments of the invention have been described above in detail, but the invention is not limited to the specific embodiments described above, and various modifications and changes can be made within the gist of the invention described in the claims.

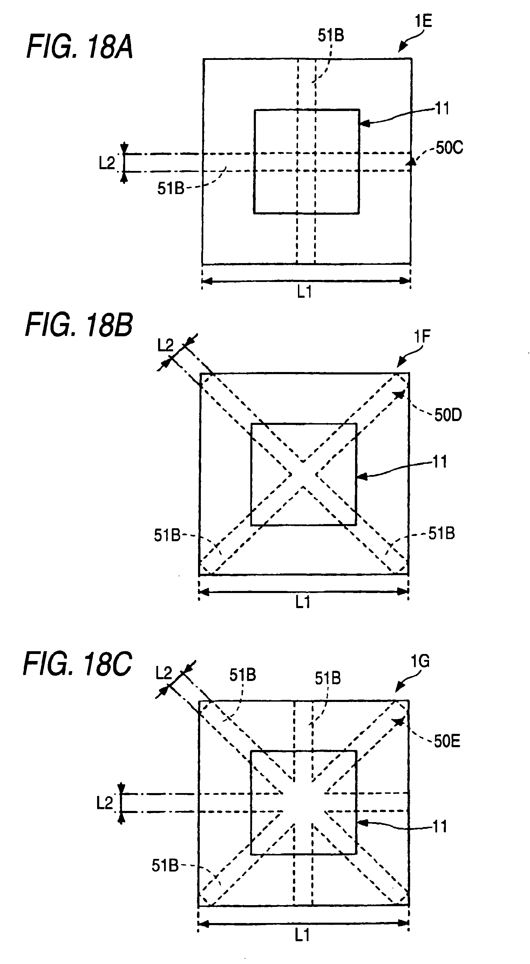

For example, in each of the embodiments described above, the shapes of the reinforcing bodies 50A, 50A-1, 50A-2, 50B are formed in the mesh shape as shown in Fig. 3, but are not limited to this mesh shape. For example, it may be configured to be placed so as to cross linear members 51B in a cross shape in plan view as described in a wiring substrate 1E shown in Fig. 18(A).

Also, a reinforcing body 50D placed so as to cross two reinforcing bodies 51B in a diagonal shape of a wiring substrate 1F in plan view may be used as described in the wiring substrate 1F shown in Fig. 18(B). Also, a reinforcing body 50E configured so as to cross plural linear members 51B in an asterisk shape may be used as described in a wiring substrate 1G shown in Fig. 18(C). Further, a form of crossing of the linear members constructing the reinforcing body can properly be changed according to a direction or a size of stress occurring inside the wiring substrate or an application direction or a size of external force which expects to be applied to the wiring substrate. In addition, in Figs. 18 (A) to 18 (C), numeral 11 shows an outline of a semiconductor chip mounted in each of the wiring substrates 1E to 1G.

Also, in each of the embodiments described above, the shapes of the linear members 51A, 51B constructing the reinforcing bodies 50A to 50E, 50-1, 50-2 are formed in the straight line shape, but it may be configured to form linear members 51A, 51B in a curved line shape, a serration shape or other shapes and cross the linear members.

Also, in the wiring substrates 1B to 1G according to each of the embodiments described above, the surface (the surface in which the first wiring layer 18 is formed) in which the support body 10 is removed is used as the surface to which the external connection terminal is connected and the opposite surface (the surface of the side in which the fifth wiring layer 18d is formed) is used as the chip installation surface. However, in reverse, the surface in which the support body 10 is removed can be used as the chip installation surface and the opposite surface can also be used as the surface to which the external connection terminal is connected.

Also, as described in the second embodiment, the wiring members 30B in which the reinforcing bodies 50A are disposed can also be formed on both surfaces of the support body 10 and in the case of using this configuration, two wiring substrates 1B can be manufactured using one support body 10, so that manufacturing efficiency can be improved. This similarly applies to each of the embodiments subsequent to the third embodiment.

Further, it may be constructed so that a layered body layered by bonding two support bodies is fabricated and wiring substrates (wiring members) are formed on both surfaces of this layered body by the method described in each of the embodiments and thereafter the bond part is removed and thereby the layered body is separated into each of the support bodies and then each of the support bodies is removed and thereby the wiring substrates are formed. By using this method, the manufacturing efficiency can be improved more.

## Claims

1. A wiring substrate (1A, 1B, 1C, 1D) comprising:
a wiring member (30A, 30B, 30C, 30D) made by layering an insulating layer (20, 20a, 20b, 20c) and a wiring layer (18, 18a, 18b, 18c, 18d), and
a reinforcing body (50A, 50A-1, 50A-2, 50B, 50D, 50E) disposed between the insulating layers of the wiring member, wherein
the reinforcing body is configured to cross plural linear members (51A, 51B).

2. The wiring substrate as claimed in claim 1, wherein
the reinforcing body is arranged in a center position with respect to a thickness direction of the wiring member.

3. The wiring substrate as claimed in claim 1 or 2, wherein
the reinforcing bodies are arranged with space upward and downward across a center position with respect to a thickness direction of the wiring member.

4. The wiring substrate as claimed in one of the claims 1 to 3, wherein
the reinforcing body has a shape selected from at least a cross shape, an asterisk shape and a mesh shape in plan view.

5. A manufacturing method of a wiring substrate, comprising the steps of:
arranging a protective member in a reinforcing body configured to cross plural linear members (51A, 51B),
forming an electrode on the protective member by a metal film (14),
forming a base half body (17a, 17b) by forming a first resin member to cover the reinforcing body and the protective member,
removing the protective member from the base half body and arranging a second resin material on a surface in which the protective member is removed,
forming an opening part for exposing the electrode in the first and second resin members,
forming a base body by forming a wiring metal layer on the inside of the opening part and surfaces of the first and second resin members, and
layering a wiring layer (18, 18a, 18b, 18c, 18d) and an insulating layer (20, 20a, 20b, 20c) on the base body to form a wiring member.

6. A manufacturing method of a wiring substrate, comprising the steps of:
layering a wiring layer and an insulating layer on a support body to form a wiring member,
removing the support body from the wiring member, and
disposing a reinforcing body (50A, 50A-1, 50A-2, 50B, 50D, 50E)configured to cross plural linear members on the insulating layer during formation of the wiring member.

7. The manufacturing method of a wiring substrate as claimed in claim 6, wherein
the step of disposing the reinforcing body is performed plural times during formation of the wiring member.

8. The manufacturing method of a wiring substrate as claimed in claim 6 or 7, wherein
the step of disposing the reinforcing body is performed one time in a case of forming the wiring member to half of the predetermined thickness during formation of the wiring member.

9. The manufacturing method of a wiring substrate as claimed in one of the claims 6 to 8, wherein
the reinforcing body is provided on the insulating layer in the step of disposing the reinforcing body.

10. The manufacturing method of a wiring substrate as claimed in one of the claims 6 to 9, wherein
the step of disposing the reinforcing body includes processing for forming the reinforcing body on the insulating layer using a plating method.
